# FASCICULE DE BREVET EUROPEEN

(11) **EP 3 942 583 B1**
(45) Date de publication et mention de la délivrance du brevet: **26.04.2023**
(21) Numéro de dépôt: 20726211.4
(22) Date de dépôt: 16.03.2020
(51) Int. Cl.: H01F 41/02, B33Y 10/00

(54) **PROCEDE DE FABRICATION ADDITIVE**
VERFAHREN ZUR GENERATIVEN FERTIGUNG
ADDITIVE MANUFACTURING METHOD

(30) Priorité: 22.03.2019 FR 1902977
(43) Date de publication de la demande: 26.01.2022
(73) Titulaire: Commissariat à l'Energie Atomique et aux Energies Alternatives, 75015 Paris (FR)
(72) Inventeur: LUCA, Sorana, 38054 GRENOBLE CEDEX 09 (FR); DELETTE, Gérard, 38054 GRENOBLE CEDEX 09 (FR); RADO, Cyril, 38054 GRENOBLE CEDEX 09 (FR)
(74) Mandataire: Brevalex
(86) Numéro de dépôt international: PCT/FR2020/050557
(87) Numéro de publication internationale: WO 2020/193909

(56) Documents cités:
- US-A1- 2017 154 713
- DAGMAR GOLL ET AL: "Refining the Microstructure of Fe-Nd-B by Selective Laser Melting", PHYSICA STATUS SOLIDI. RAPID RESEARCH LETTERS, vol. 13, no. 3, 1 mars 2019 (2019-03-01), page 1800536, XP055657927, DE ISSN: 1862-6254, DOI: 10.1002/pssr.201800536
- WHITE EMMA MARIE HAMILTON ET AL: "Net Shape Processing of Alnico Magnets by Additive Manufacturing", IEEE TRANSACTIONS ON MAGNETICS, IEEE SERVICE CENTER, NEW YORK, NY, US, vol. 53, no. 11, 1 novembre 2017 (2017-11-01), pages 1-6, XP011671731, ISSN: 0018-9464, DOI: 10.1109/TMAG.2017.2711965 [extrait le 2017-10-24]
- JACIM JACIMOVIC ET AL: "Net Shape 3D Printed NdFeB Permanent Magnet? : Net Shape 3D Printed NdFeB Permanent Magnet", ADVANCED ENGINEERING MATERIALS., vol. 19, no. 8, 1 août 2017 (2017-08-01), page 1700098, XP055491039, DE ISSN: 1438-1656, DOI: 10.1002/adem.201700098 cité dans la demande

## Description

### DOMAINE TECHNIQUE

L'invention concerne un procédé de fabrication additive pour la formation de pièces polarisées. En particulier, la présente invention concerne un procédé de fabrication additive pour la formation d'aimants.

### ÉTAT DE LA TECHNIQUE ANTÉRIEURE

Les aimants frittés à base de terres rares, du fait de leurs performances, sont aujourd'hui abondamment utilisés. Leur fabrication implique généralement la mise en forme de poudres, et plus particulièrement le frittage desdites poudres.

À cet égard, un procédé de fabrication d'un aimant, qualifié d'anisotrope dans la suite, connu de l'état de la technique, comprend les étapes suivantes :
a) une étape de synthèse d'un alliage magnétique par fusion et refroidissement rapide, par exemple sur roue (« strip casting » selon la terminologie Anglo-Saxonne), de manière à former des précurseurs solides de la phase magnétique sous forme de rubans ;
b) une étape de broyage des rubans sous forme d'une poudre, présentant par exemple une granulométrie comprise entre 5 µm et 10 µm, à l'issue de cette étape, la poudre broyée est constituée d'une grande quantité de petits cristaux polarisables appelés grains. Chaque grain est lui-même un réseau périodique d'atomes répartis selon un motif géométrique, appelé maille cristalline. La polarisation est toujours dirigée selon un axe préférentiel de la maille, appelé axe de facile polarisation (ou axe de facile aimantation dans le cas des matériaux magnétiques) et peut être orientée selon les deux sens définis par l'axe de facile polarisation (positif ou négatif). Ainsi, dans un empilement de grains formés par de la poudre broyée, chacun des axes de facile polarisation pointe dans une direction aléatoire, si bien que l'empilement de poudre à un caractère isotrope ;
c) une étape d'alignement magnétique des poudres sous un champ magnétique, par exemple compris entre 5 Teslas et 8 Teslas, afin d'orienter la direction de facile polarisation de chaque grain selon une direction donnée, de sorte qu'à l'issue de l'étape c) l'empilement de poudre présente un caractère anisotrope ;
d) une étape de mise en forme par compaction à froid des poudres orientées conservant l'anisotropie de la poudre ;
e) une étape de frittage, à une température comprise entre 1000°C et 1200 °C afin de densifier la pièce compactée à l'étape d) tout en conservant l'alignement des grains;
f) une ou plusieurs étapes de recuit à des températures inférieures à la température de frittage pour développer les propriétés magnétiques ;

À l'issue de l'étape f), la pièce peut également être rectifiée.

La pièce peut également être aimantée sous champ magnétique, par exemple sous un champ magnétique d'une intensité supérieure à 5 Teslas. En particulier, la direction de l'aimantation résiduelle dans l'aimant est alignée selon la direction d'alignement des grains obtenue lors de l'étape c) et le sens de l'aimantation résiduelle (c'est-à-dire le sens de la polarisation N-S de l'aimant dépend du sens du champ magnétique appliqué).

Les aimants anisotropes présentent en général les caractéristiques magnétiques maximales, la polarisation résiduelle (ou aimantation résiduelle) est notamment deux fois supérieure à celle du même aimant isotrope produit sans l'étape c).

Les aimants obtenus par un tel procédé connu de l'état de la technique présentent généralement une micro structure homogène (à une échelle supérieure à 10 µm) en termes de composition, de porosité, de taille et de forme des grains. Ces paramètres conditionnent les propriétés des aimants, notamment leur rémanence et leur coercivité.

Cependant, ce procédé de frittage pour la mise en forme d'un aimant n'est pas satisfaisant.

En effet, les aimants sont le siège de pertes magnétiques qui provoquent leur échauffement, et ultimement une altération de leurs propriétés magnétiques. Afin de limiter cet effet, il est possible de les structurer géométriquement, par exemple sous forme de lamelles. Toutefois, cette solution, du fait de la fragilité des aimants frittés, est difficilement envisageable.

Par ailleurs, une modulation spatiale de la direction de l'aimantation de l'aimant est parfois requise. Un tel résultat peut être obtenu en appliquant un champ magnétique non uniforme lors de l'exécution de l'étape c). Cependant, une modulation spatiale de la direction de l'aimantation sur une échelle inférieure au millimètre est difficile, voire impossible, à réaliser.

De manière alternative au procédé de frittage connu de l'état de la technique, la fabrication additive semble faire aujourd'hui une percée notable tant dans le domaine du prototypage que celui de la production en série.

Cette technique permet notamment de réaliser des aimants structurés.

À cet égard, le document [1] cité à la fin de la description propose un procédé de fabrication additive d'aimants liés. Plus particulièrement, ce procédé comprend une dilution de poudres magnétiques dans un liant organique. Cependant cette dilution affecte de manière notable les performances des aimants ainsi obtenus.

Le document [2] cité à la fin de la description propose également un procédé de fabrication additive d'aimants. Notamment, ce procédé comprend une condensation sur un substrat de poudres, faites de NdFeB, projetées par un faisceau laser.

Toutefois, les aimants obtenus par ce procédé sont isotropes.

Par ailleurs, la coercivité des aimants ainsi obtenus est altérée par la présence, en son sein, d'une phase magnétique douce qui comprend du fer en phase cubique (fer dit « alpha »).

Les documents [3] à [5] cités à la fin de la description proposent un procédé de fabrication d'aimants par fusion sur lit de poudre (par exemple de NdFeB) par un faisceau laser. Toutefois, aucun de ces documents ne révèle la méthode permettant d'induire une aimantation dans les aimants ainsi formés.

Le document [6] cité à la fin de la description proposent également un procédé de fabrication d'aimants par fusion sur lit de poudre (par exemple de NdFeB) par un faisceau laser, et mettant en oeuvre l'application d'un champ magnétique de 1 tesla à 15 tesla afin d'induire une phase magnétique.

De telles valeurs de champ magnétique sont toutefois contraignantes, et ne peuvent être mises en oeuvre facilement dans le cadre de prototypages ou d'une production en grande série.

Le document DAGMAR GOLL ET AL., PHYSICA STATUS SOLIDI. RAPID RESEARCH LETTERS, vol. 13, page 1800536; DOI: 10.1002/pssr.201800536 couvre un procédé de fabrication additive d'aimant Fe-Nd-B où des couches de poudres sont consolidées localement par fusion par faisceau laser selon une direction de croissance perpendiculaire à l'axe c de la phase Φ.

Le document WHITE EMMA MARIE HAMILTON ET AL., IEEE TRANSACTIONS ON MAGNETICS, vol. 53, page 2101606; DOI: 10.1109/TMAG.2017.2711965 couvre un procédé de fabrication additive d'un aimant alnico 8, où les échantillons sont déposés sur des substrats orientés d'alnico 9 et traités thermiquement, pour former un solide ayant une microstructure isotrope.

Un but de la présente invention est donc de proposer un procédé de fabrication additive d'aimants ne nécessitant pas l'application d'un champ magnétique.

Un autre but de la présente invention est également de proposer un procédé de fabrication additive permettant d'imposer à l'aimant une modulation spatiale de son aimantation sur une échelle inférieure au millimètre.

Un autre but de la présente invention est également de proposer un procédé de fabrication additive permettant de conférer à l'aimant des formes inaccessibles par le procédé de frittage connu de l'état de la technique.

### EXPOSÉ DE L'INVENTION

Les buts de l'invention sont, au moins en partie, atteints comme définis dans la revendication 1, par un procédé de fabrication additive d'une ou plusieurs sections polarisées d'une pièce à partir d'un ou plusieurs germes de cristallisation présentant une surface de cristallisation en affleurement avec une face avant d'un plateau, le procédé comprenant les étapes suivantes :
a) la formation d'une couche de poudre d'un matériau polarisable, sur la face avant ;
b) une fusion sélective d'une région de la couche de poudre circonscrite par la surface de cristallisation ;
c) l'application d'un gradient thermique selon l'épaisseur de la couche de manière à solidifier la région fondue à l'étape c) ;
d) une répétition des étapes a), b) et c) de manière à former l'au moins une section par empilage de couches fusionnées, lesdites couches fusionnées étant formées de grains polarisables selon une direction de facile polarisation ;

Le germe de cristallisation présente une cristallinité adaptée pour imposer aux grains une orientation préférentielle de sorte que chacune des couches fusionnées soit polarisable sous l'effet d'un champ de polarisation et que la polarisation résiduelle de la couche après polarisation par un champ de polarisation soit dirigée dans la direction prédéfinie par le germe.

Le germe de cristallisation selon la présente invention permet de choisir l'orientation cristalline (et notamment des axe cristallographique) des grains par rapport à la face avant du plateau.

Il est entendu, sans qu'il soit nécessaire de le préciser que l'orientation préférentielle est celle de la direction de facile polarisation.

Par « axe de facile polarisation », on entend une direction privilégiée selon laquelle la polarisation s'oriente. Un axe de facile polarisation peut être un axe cristallin particulier.

Par « matériau polarisable », on entend un matériau qui présente une polarisation résiduelle (magnétique ou électrique) après exposition à un champ électromagnétique externe. La polarisation résiduelle est dirigée selon un axe cristallographique particulier, dit axe de « facile » polarisation.

Selon un mode de mise en oeuvre, le procédé comprend en outre une étape e) de polarisation de la section, l'étape e) comprenant l'exposition de ladite section à un champ de polarisation.

Selon un mode de mise en oeuvre, l'étape b) de fusion est exécutée au moyen d'un laser, avantageusement au moyen d'un laser balayant la surface exposée de la région prédéterminée.

Selon un mode de mise en oeuvre, le gradient thermique est imposé par la circulation d'un fluide caloporteur dans un ou des conduits de circulation ménagés dans le volume du plateau.

Selon un mode de mise en oeuvre, plusieurs germes de cristallisation sont disposés en affleurement avec la face avant du plateau, et de sorte qu'à l'issue de l'étape d), la pièce comprenne une pluralité de sections polarisables, avantageusement selon des directions différentes.

Il est ainsi possible de moduler la polarisation la pièce à une échelle supérieure à 10 µm.

Selon un mode de mise en oeuvre, l'ensemble des germes de cristallisation forme une bague, de sorte qu'à l'issue de l'étape d), la pièce forme avec ses sections un ensemble monobloc également en forme de bague, chacune des sections étant polarisable selon une direction radiale à la bague.

Selon un mode de mise en oeuvre, la surface de cristallisation présente une forme et une orientation cristalline adaptées pour la formation d'une section de forme cylindrique et polarisable selon l'axe de révolution de ladite pièce.

Selon un mode de mise en oeuvre, la surface de cristallisation présente une forme et une orientation cristalline adaptées pour la formation d'une section de forme cubique et polarisable selon une direction perpendiculaire à la face avant.

Selon un mode de mise en oeuvre, l'au moins un germe de cristallisation est de forme monocristalline ou polycristalline orientée.

Selon un mode de mise en oeuvre, l'au moins un germe de cristallisation est chimiquement différent du matériau polarisable, avantageusement l'au moins un germe de cristallisation comprend au moins un des éléments choisi parmi : MgO, Si.

Selon un mode de mise en oeuvre, l'au moins un germe de cristallisation et le matériau polarisable comprennent le même matériau.

Selon un mode de mise en oeuvre, le matériau polarisable est polarisable magnétiquement.

### BRÈVE DESCRIPTION DES DESSINS

D'autres caractéristiques et avantages apparaîtront dans la description qui va suivre d'un procédé de fabrication additive selon l'invention, donnés à titre d'exemples non limitatifs, en référence aux dessins annexés dans lesquels :
La figure 1 est une représentation schématique selon un plan de coupe d'un dispositif de fabrication additive susceptible d'être mis en oeuvre dans le cadre de la présente invention ;
La figure 2 est un premier exemple de fabrication d'un aimant par le procédé de fabrication additive selon la présente invention ;
La figure 3 est un deuxième exemple de fabrication d'un aimant par le procédé de fabrication additive selon la présente invention ;
La figure 4 est un troisième exemple de fabrication d'un aimant par le procédé de fabrication additive selon la présente invention ;

### EXPOSÉ DÉTAILLÉ DE MODES DE RÉALISATION PARTICULIERS

La présente invention concerne un procédé de fabrication additive d'une pièce polarisée selon une direction de polarisation.

Par « pièce polarisée », on entend une pièce présentant une polarisation résiduelle magnétique (par exemple un aimant) ou une polarisation résiduelle électrique (par exemple pour un matériau ferroélectrique).

Par « pièce polarisable » ou « section polarisable », on entend une pièce ou une section qui lorsqu'elle est soumise à un champ de polarisation, notamment un champ de polarisation selon une direction de facile polarisation, présente une polarisation permanente, également appelée polarisation résiduelle.

En particulier, le champ de polarisation peut être un champ magnétique de sorte que la polarisation résiduelle soit une polarisation résiduelle magnétique (aussi appelé « aimantation »).

De manière équivalente, le champ de polarisation peut être un champ électrique de sorte que la polarisation résiduelle soit une polarisation électrique.

La polarisation résiduelle est, selon les termes de la présente invention, orientée selon au moins un axe privilégié, dit « direction de facile polarisation ». Ce dernier est généralement fonction de l'orientation cristallographique du matériau formant la pièce considérée.

Par « direction de facile polarisation », on entend un axe selon lequel l'ensemble des dipôles, magnétiques ou électriques, s'orientent dès lors qu'ils sont soumis à un champ de polarisation.

Le procédé concerne donc la fabrication additive d'une ou plusieurs sections polarisées d'une pièce à partir d'un ou plusieurs germes de cristallisation présentant une surface de cristallisation en affleurement avec une face avant d'un plateau, le procédé comprenant les étapes suivantes :
a) la formation d'une couche de poudre d'un matériau polarisable, sur la face avant ;
b) une fusion sélective d'une région de la couche de poudre circonscrite par la surface de cristallisation ;
c) l'application d'un gradient thermique de manière à générer la propagation d'un front de solidification, à partir de la surface de cristallisation et selon une direction perpendiculaire à la face avant, au sein de de la région fondue, de manière à solidifier cette dernière ;
d) une répétition des étapes a), b) et c) de manière à former l'au moins une section par empilage de couches fusionnées, lesdites couches fusionnées étant formées de grains polarisables, chacun selon une direction de facile polarisation ;

Le germe de cristallisation présente une cristallinité adaptée pour imposer aux grains une orientation de sorte que chacune des couches fusionnées soit polarisable sous l'effet d'un champ de polarisation.

La suite de la description est limitée à un procédé de fabrication additive d'un aimant. Toutefois, l'homme du métier avec ses connaissances générales peut adapter les concepts décris pour la fabrication de pièces présentant une polarisation électrique telles que des pièces ferroélectriques.

Par ailleurs, il est entendu tout au long de la description qu'une polarisation, qu'elle soit magnétique ou électrique, est la conséquence d'un ordre cristallin au sein de la pièce concernée. En particulier, un ordre cristallin, au sens de la présente invention, peut signifier une pièce monocristalline ou une pièce polycristalline faite de grains présentant une orientation cristallographique préférentielle.

Sur ce dernier point, tout au long la description, il sera considéré qu'une pièce polycristalline présente un ordre cristallin si au moins 50 %, préférentiellement au moins 75%, encore plus préférentiellement au moins 90%, de ses grains sont préférentiellement orientés selon une direction cristallographique particulière.

Tel que précisé précédemment, la polarisation d'une pièce résulte d'un ordre cristallin de ladite pièce. Notamment, la direction cristallographique associée à cet ordre cristallin défini également une direction de facile polarisation, et plus particulièrement de facile aimantation.

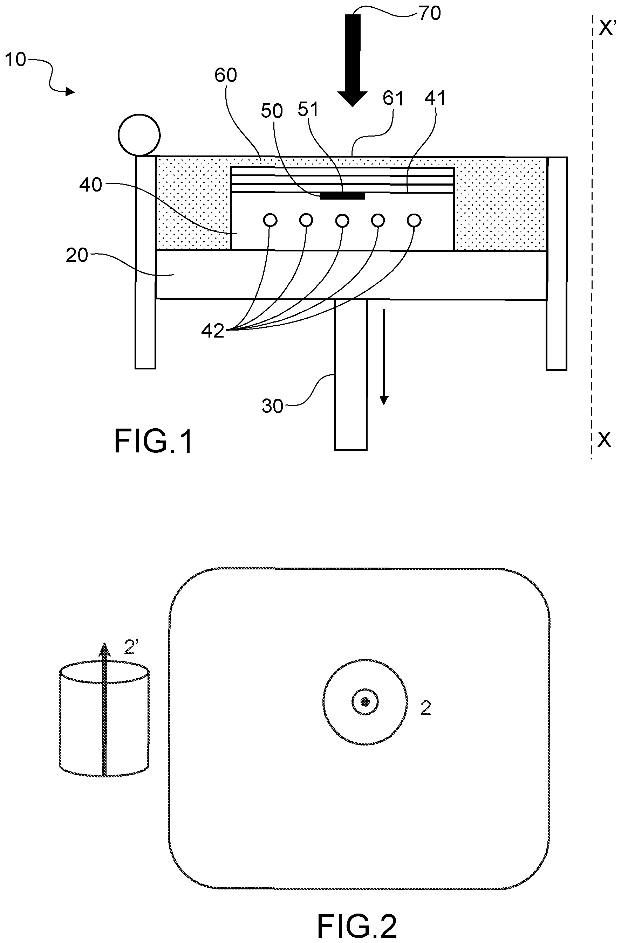

La figure 1 est une représentation schématique d'un dispositif 10 permettant de mettre en oeuvre la présente invention.

Le dispositif de fabrication additive 10 comprend en particulier un support 20 monté sur un arbre 30 adapté pour assurer un mouvement de translation du support selon une direction XX' perpendiculaire à une face dudit support.

Un plateau 40, comprenant une face avant 41, est disposé sur le support 20. Le plateau peut comprendre un ou plusieurs conduits 42 au travers desquels peut circuler un fluide caloporteur destiné à réguler la température du plateau 40.

Au moins un germe de cristallisation 50 est également disposé sur ou dans le plateau 40. Notamment, l'au moins un germe comprend une surface de cristallisation 51 en affleurement avec la face avant 41 du plateau 40.

Le germe de cristallisation est notamment un germe présentant un ordre cristallin et une orientation cristalline. Le choix de l'orientation cristalline est fonction de critères qui seront détaillés dans la suite de l'énoncé.

La mise en oeuvre d'un tel dispositif pour l'exécution d'un procédé de fabrication additive comprend dans un premier temps la formation d'une couche de poudre 60 en recouvrement de la face avant 41 (étape a)).

Cette couche de poudre 60 peut en particulier être formée avec un rouleau 70 (ou une raclette).

L'épaisseur de la couche de poudre 60 peut être comprise entre 10 et 100 µm.

L'étape de formation de la couche de poudre est suivie d'une étape b) de fusion sélective d'une région 61 de la couche de poudre 60.

Notamment, la région 61 est circonscrite par la surface de cristallisation 51.

La fusion sélective peut être exécutée au moyen d'un faisceau laser, et notamment au moyen d'un faisceau laser balayant la surface de la région.

Le procédé selon la présente invention comprend également une étape c) de solidification de la région 61 fondue lors de l'étape b).

Cette solidification est notamment contrôlée en imposant un gradient thermique à la région 61 fondue lors de l'étape b). Le gradient thermique peut être imposé par la circulation d'un fluide caloporteur dans le ou les conduits 42.

Il est entendu, sans qu'il soit nécessaire de le préciser, que le gradient thermique est imposé selon une direction perpendiculaire à la face avant.

Il est également entendu, sans qu'il soit nécessaire de le préciser, que le gradient thermique impose une direction de propagation d'un front de solidification de la région fondu. Notamment ce front de solidification se propage de la face avant vers la face exposée de la région fondue.

Dès lors que l'étape b) est mise en oeuvre avec un laser balayant la région, il est également entendu que la solidification de l'étape b) peut se produire dans le sillage du laser.

La mise en oeuvre combinée du germe de cristallisation orienté et du gradient thermique permet d'imposer, lors de l'étape c) de solidification, une solidification dirigée et un ordre cristallin à la région 61.

En d'autres termes, la région 61 solidifiée à l'issue de l'étape c) présente un ordre cristallin et est polarisable selon une direction qui est fonction de l'orientation cristalline du germe de cristallisation.

L'amplitude du gradient thermique impose également la vitesse de propagation et/ou la cristallinité de la région 61 à l'issue de l'étape c). À cet égard, le document [10] cité à la fin de la description fournit toutes les informations nécessaires permettant d'ajuster le gradient thermique en fonction du degré de cristallinité à atteindre.

En particulier, le gradient thermique est ajusté de manière à obtenir une région, à l'issue de l'étape c), monocristalline ou polycristalline avec des grains colonnaires perpendiculaires à la face avant.

Le procédé selon la présente invention comprend alors une répétition des étapes a), b), et c) autant de fois que nécessaire de manière à obtenir une section d'une pièce par empilage de couches fusionnées.

Il est entendu, sans qu'il soit nécessaire de le préciser, que la région solidifiée à l'issue d'une étape c) constitue un germe de cristallisation pour l'exécution d'un nouveau cycle d'étapes a), b), et c).

De manière complémentaire, l'étape a) peut être précédée d'une étape a1) de préchauffage du plateau, par exemple à une température comprise entre 250°C et 500 °C.

Enfin, le procédé peut comprendre une étape e) de polarisation de la section, l'étape comprenant l'exposition de ladite section à un champ de polarisation.

Le procédé décrit ci-avant est donc avantageusement mis en oeuvre pour la fabrication d'aimants. La polarisation (aimantation) de ces derniers résultant de leur ordre cristallin est imposée par le choix et l'orientation cristalline du germe de cristallisation.

Selon un premier exemple illustré à la figure 2, le germe de cristallisation peut présenter une surface de cristallisation en forme de disque 2 et une orientation cristalline favorisant la formation d'une pièce 2' de forme cylindrique et dont la polarisation est perpendiculaire à la face avant.

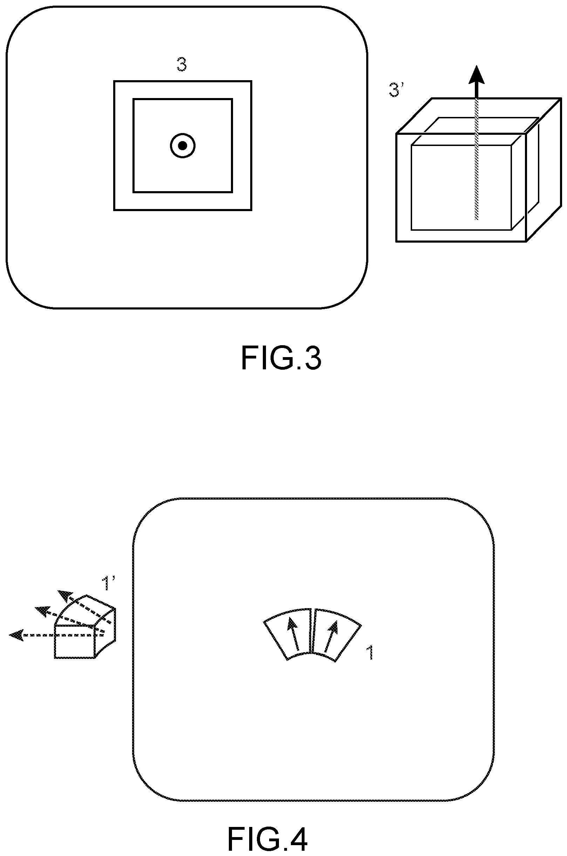

Selon un second exemple illustré à la figure 3, le germe de cristallisation peut présenter une surface de cristallisation en forme carrée 3 et une orientation cristalline favorisant la formation d'une pièce 3' de forme cubique et dont la polarisation est perpendiculaire à la face avant. La pièce comprend en outre couche d'enrobage faiblement polarisée. Cette couche d'enrobage est notamment obtenue par exécution des étapes a) et b) de la présente invention, et une étape de solidification lors de laquelle aucun gradient thermique n'est imposé.

Selon un dernier exemple illustré à la figure 3, une pluralité de germes 1 peut être disposée sur le plateau. Notamment chaque germe peut présenter une surface cristalline 1 en forme d'arc plein. L'ensemble des germes peut en particulier former une bague. La mise en oeuvre du procédé de fabrication additive permet alors de former un aimant 1' monobloc et comprenant une pluralité de sections aimantés présentant chacune une polarisation selon une direction qui lui est propre.

La formation d'un aimant monobloc comprenant une pluralité de sections présentant chacune une polarisation selon une direction qui lui est propre n'est pas limitée à une forme de bague et peut être généralisée à toute autre forme.

Selon une variante de la présente invention, l'au moins un germe peut être chimiquement différent de la pièce formée.

À titre d'exemple, la fabrication additive d'aimants comprenant du SmCo peut mettre en oeuvre un germe de MgO monocristallin d'orientation [110] recouvert d'une couche buffer de 10-20 nm de Cr. La couche buffer, tel que décrit dans le document [7] cité à la fin de la description, permet de contrôler les propriétés magnétiques de l'aimant.

Toujours à titre d'exemple, la fabrication additive d'aimants de NdFeB peut mettre en oeuvre un germe de MgO monocristallin d'orientation [110] recouvert d'une couche buffer d'une épaisseur comprise entre 10 nm et 20 nm de Cr ou de Ta, ou un germe de Si monocristallin d'orientation [001] recouvert d'une couche buffer de Ta d'une épaisseur comprise entre 80nm et 100 nm. Les documents [8] et [9] cités à la fin de la description présentent les avantages relatifs à ces configurations.

Selon une autre variante, le germe et l'aimant peuvent être de même nature chimique. En particulier, le germe peut être au choix monocristallin ou polycristallin et présenter un ordre cristallin.

Le procédé de fabrication additive peut également comprendre un ou plusieurs traitements thermiques destinés à homogénéiser la pièce, et ajuster sa microstructure de manière à obtenir des propriétés magnétiques particulières.

De manière complémentaire, le gradient thermique d'un cycle d'étapes a), b) et c) à l'autre peut varier de manière à modifier localement les propriétés magnétiques de l'aimant, et notamment d'une couche à l'autre. Cet ajustement permet de moduler localement les propriétés magnétiques et thermomécaniques afin de protéger des zones des aimants soumises à des champs démagnétisants et/ou des contraintes mécaniques élevées.

Toujours de manière complémentaire, la composition chimique de la poudre étendue à l'étape a) peut varier d'un cycle d'étapes a), b) et c) à l'autre de manière à modifier localement les propriétés magnétiques de l'aimant.

Cet ajustement peut notamment être exécuté afin d'augmenter le champ coercitif localement, dans des endroits soumis à des champs démagnétisants plus forts.

Ainsi, selon la présente invention, il est possible de former par un procédé de fabrication additive des aimants anisotropes sans nécessiter le recours à un champ magnétique pour l'alignement des grains.

Il est également possible de former des aimants présentant une modulation spatiale de leur aimantation sur une échelle inférieure au millimètre.

### RÉFÉRENCES

[1] : Ling Li et al., « Additive manufacturing of near-net-shape bonded magnets: Prospects and challenges », Scripta Materialia, 135, 100-104, (2017) ;
[2] : Niyanth Sridharan et al., « Rationalization of solidification mechanism of Nd-Fe-B magnets during laser directed-energy déposition », J. Mater. Sci., 53, 8619-8626, (2018) ;
[3] : J. Jacimovic et al., « Net Shape 3D Printed NdFeB Permanent Magnet », Advanced Engineering Material, 19(8), (2017) ;
[4] : Nikolaus Urban et al., « Additive Manifaturing of an Electric Device », International Symposium on Power electronics, Electrical Drives, Automation and Motion, (2018) ;
[5] : US 2017/0154713 ;
[6] : US 2016/0375492 ;
[7] : A.Singh et al., « Pulsed laser deposited epitaxial Sm-Co thin films with uniaxial magnetic texture », Journal of Applied Physics, 99, 08E917, (2006) ;
[8] : A.R.Kwon et al., « Microstructure and magnetic properties of highly textured Nd-Fe-B films grown on Ta (1 0 0) », Journal of Magnetism and Magntic Materials, 290-291, 1247-1250, (2005) ;
[9] : Dempsey et al., « High performance hard magnetic NdFeB thick films for intégration into micro-electro-mechanical systems », Applied physics Letters, 90, 09209 (2007) ;
[10] : W. Kurz et al., « Columnar to equiaxed transition in solidification processing », 2, 185-191, (2001).

## Revendications

1. Procédé de fabrication additive d'une ou plusieurs sections polarisées d'une pièce à partir d'un ou plusieurs germes de cristallisation présentant une surface de cristallisation en affleurement avec une face avant d'un plateau, le procédé comprenant les étapes suivantes :
a) la formation d'une couche de poudre d'un matériau polarisable sur la face avant ;
b) une fusion sélective d'une région de la couche de poudre circonscrite par la surface de cristallisation ;
c) l'application d'un gradient thermique de manière à initier la propagation d'un front de solidification, à partir de la surface de cristallisation et selon une direction perpendiculaire à la face avant, au sein de la région fondue, de manière à solidifier cette dernière ;
d) une répétition des étapes a), b) et c) de manière à former l'au moins une section par empilage de couches fusionnées, lesdites couches fusionnées étant formées de grains polarisables selon une direction de facile polarisation ;
et dans lequel le ou les germes de cristallisation présentent une cristallinité adaptée pour imposer aux grains une orientation préférentielle de sorte que chacune des couches fusionnées soit polarisable sous l'effet d'un champ de polarisation et que la polarisation résiduelle de la couche après polarisation par un champ de polarisation soit dirigée dans la direction prédéfinie par le ou les germes de cristallisation.

2. Procédé selon la revendication 1, dans lequel le procédé comprend en outre une étape e) de polarisation de la section, l'étape e) comprenant l'exposition de ladite section à un champ de polarisation.

3. Procédé selon la revendication 1 ou 2, dans lequel l'étape b) de fusion est exécutée au moyen d'un laser, avantageusement au moyen d'un laser balayant la surface exposée de la région prédéterminée.

4. Procédé selon l'une des revendications 1 à 3, dans lequel le gradient thermique est imposé par la circulation d'un fluide caloporteur dans un ou des conduits de circulation ménagés dans le volume du plateau.

5. Procédé selon l'une des revendications 1 à 4, dans lequel plusieurs germes de cristallisation sont disposés en affleurement avec la face avant du plateau, et de sorte qu'à l'issue de l'étape d), la pièce comprenne une pluralité de sections polarisables, avantageusement selon des directions différentes.

6. Procédé selon la revendication 5, dans lequel l'ensemble des germes de cristallisation forme une bague, de sorte qu'à l'issue de l'étape d), la pièce forme avec ses sections un ensemble monobloc également en forme de bague, chacune des sections étant polarisable selon une direction radiale à la bague.

7. Procédé selon l'une des revendications 1 à 4, dans lequel la surface de cristallisation présente une forme et une orientation cristalline adaptées pour la formation d'une section de forme cylindrique et polarisable selon l'axe de révolution de ladite pièce.

8. Procédé selon l'une des revendications 1 à 4, dans lequel la surface de cristallisation présente une forme et une orientation cristalline adaptées pour la formation d'une section de forme cubique et polarisable selon une direction perpendiculaire à la face avant.

9. Procédé selon l'une des revendications 1 à 8, dans lequel l'au moins un germe de cristallisation est de forme monocristalline ou polycristalline orientée.

10. Procédé selon l'une des revendications 1 à 9, dans lequel l'au moins un germe de cristallisation est chimiquement différent du matériau polarisable, avantageusement l'au moins un germe de cristallisation est choisi comprenant au moins l'un parmi MgO, Si.

11. Procédé selon l'une des revendications 1 à 9, dans lequel l'au moins un germe de cristallisation et le matériau polarisable comprennent le même matériau.

12. Procédé selon l'une des revendications 1 à 10, dans lequel le matériau polarisable est polarisable magnétiquement.

## Patentansprüche

1. Verfahren zur additiven Fertigung eines oder mehrerer gepolter Abschnitte eines Werkstücks aus einem oder mehreren Kristallisationskeimen, die eine mit einer Vorderseite einer Platte bündige Kristallisationsoberfläche aufweisen, wobei das Verfahren die folgenden Schritte umfasst:
a) die Bildung einer Pulverschicht aus einem polarisierbaren Werkstoff an der Vorderseite;
b) eine selektive Verschmelzung einer Region der Pulverschicht, die von der Kristallisationsoberfläche eingegrenzt ist;
c) die Anwendung eines Temperaturgradienten, um die Ausbreitung einer Erstarrungsfront aus der Kristallisationsoberfläche und entlang einer zur Vorderseite senkrechten Richtung innerhalb der verschmolzenen Region einzuleiten, um letztere erstarren zu lassen;
d) eine Wiederholung der Schritte a), b) und c) um den mindestens einen Abschnitt durch Stapeln verschmolzener Schichten zu bilden, wobei die verschmolzenen Schichten aus polarisierbaren Körnern entlang einer einfachen Polarisierungsrichtung gebildet werden;
und wobei der oder die Kristallisationskeim(e) eine Kristallinität aufweist (aufweisen), die angepasst ist, um den Körnern eine bevorzugte Ausrichtung aufzuerlegen, damit jede der verschmolzenen Schichten unter der Wirkung eines Polarisierungsfeldes polarisierbar ist, und die Restpolarisierung der Schicht nach Polarisierung durch ein Polarisierungsfeld in der durch den oder die Kristallisationskeim(e) vordefinierten Richtung geleitet wird.

2. Verfahren nach Anspruch 1, wobei das Verfahren weiter einen Schritt e) des Polarisierens des Abschnitts umfasst, wobei der Schritt e) die Aussetzung des Abschnitts einem Polarisierungsfeld umfasst.

3. Verfahren nach Anspruch 1 oder 2, wobei der Schritt b) des Verschmelzens anhand eines Lasers, vorteilhafterweise anhand eines Lasers ausgeführt wird, der die exponierte Oberfläche der vorbestimmten Region abscannt.

4. Verfahren nach einem der Ansprüche 1 bis 3, wobei der Temperaturgradient durch die Zirkulation einer Wärmeträgerflüssigkeit in einer oder den Zirkulationsleitungen auferlegt wird, die in dem Volumen der Platte eingearbeitet sind.

5. Verfahren nach einem der Ansprüche 1 bis 4, wobei mehrere Kristallisationskeime mit der Vorderseite der Platte bündig und derart angeordnet sind, dass das Werkstück am Ende von Schritt d) eine Vielzahl von polarisierbaren Abschnitten, vorteilshalber entlang unterschiedlicher Richtungen umfasst.

6. Verfahren nach Anspruch 5, wobei die Gesamtheit der Kristallisationskeime einen Ring bildet, sodass das Werkstück mit seinen Abschnitten am Ende von Schritt d) eine Einheit in einem Stück ebenfalls in Ringform bildet, wobei jeder der Abschnitte entlang einer zum Ring radialen Richtung polarisierbar ist.

7. Verfahren nach einem der Ansprüche 1 bis 4, wobei die Kristallisationsoberfläche eine Form und eine Kristallorientierung aufweist, die zur Bildung eines Abschnitts in zylindrischer Form, und entlang der Drehachse des Werkstücks polarisierbar angepasst sind.

8. Verfahren nach einem der Ansprüche 1 bis 4, wobei die Kristallisationsoberfläche eine Form und eine Kristallorientierung aufweist, die zur Bildung eines Abschnitts in kubischer Form, und entlang einer zur Vorderseite senkrechten Richtung polarisierbar angepasst sind.

9. Verfahren nach einem der Ansprüche 1 bis 8, wobei der mindestens eine Kristallisationskeim in einer einkristallinen oder ausgerichteten mehrkristallinen Form ist.

10. Verfahren nach einem der Ansprüche 1 bis 9, wobei sich der mindestens eine Kristallisationskeim chemisch von dem polarisierbaren Werkstoff unterscheidet, wobei der mindestens eine Kristallisationskeim vorzugsweise aus mindestens einem aus MgO, Si umfassend ausgewählt wird.

11. Verfahren nach einem der Ansprüche 1 bis 9, wobei der mindestens eine Kristallisationskeim und der polarisierbare Werkstoff denselben Werkstoff umfassen.

12. Verfahren nach einem der Ansprüche 1 bis 10, wobei der polarisierbare Werkstoff magnetisch polarisierbar ist.

## Claims

1. A method for additively manufacturing one or more polarised sections of a part from one or more crystallisation nuclei having a crystallisation surface flush with a front face of a platen, the method comprising the following steps:
a) forming a powder layer of a polarisable material on the front face;
b) selectively fusing a region of the powder layer circumscribed by the crystallisation surface;
c) applying a thermal gradient so as to initiate propagation of a solidification front, from the crystallisation surface and along a direction perpendicular to the front face, within the molten region, so as to solidifying the same;
d) repeating steps a), b) and c) so as to form the at least one section by stacking fused layers, said fused layers being formed of grains polarisable along a direction of easy polarisation;
and wherein the crystallisation nucleus or nuclei have a crystallinity adapted to impose a preferential orientation to the grains so that each of the fused layers is polarisable under the effect of a polarising field and that the residual polarisation of the layer after polarisation by a polarisation field is directed in the predefined direction by the crystallisation nucleus or nuclei.

2. The method according to claim 1, wherein the method further comprises a step e) of polarising the section, step e) comprising exposing said section to a polarisation field.

3. The method according to claim 1 or 2, wherein the fusion step b) is performed by means of a laser, advantageously by means of a laser scanning the exposed surface of the predetermined region.

4. The method according to any of claims 1 to 3, wherein the thermal gradient is imposed by circulating a heat transfer fluid in one or more circulation ducts provided in the platen volume.

5. The method according to one of claims 1 to 4, wherein several crystallisation nuclei are disposed flush with the front face of the platen, and so that at the end of step d), the part comprises a plurality of polarisable sections, advantageously along different directions.

6. The method according to claim 5, wherein all the crystallisation nuclei form a ring, so that at the end of step d), the part forms with its sections a single-piece assembly also in a ring shape, each of the sections being polarisable along a direction radial to the ring.

7. The method according to one of claims 1 to 4, wherein the crystallisation surface has a shape and a crystal orientation adapted to the formation of a cylindrical shaped section polarisable along an axis of revolution of said part.

8. The method according to one of claims 1 to 4, wherein the crystallisation surface has a shape and a crystal orientation adapted to the formation of a cubic shaped section polarisable along a direction perpendicular to the front face.

9. The method according to one of claims 1 to 8, wherein the at least one crystallisation nucleus is of an oriented single-crystal or polycrystalline shape.

10. The method according to one of claims 1 to 9, wherein the at least one crystallisation nucleus is chemically different from the polarisable material, advantageously the at least one crystallisation nucleus is selected from at least one of MgO, Si.

11. The method according to one of claims 1 to 9, wherein the at least one crystallisation nucleus and the polarisable material comprise the same material.

12. The method according to one of claims 1 to 10, wherein the polarisable material is magnetically polarisable.
